# EUROPEAN PATENT SPECIFICATION

(11) **EP 3 442 010 B1**
(45) Date of publication and mention of the grant of the patent: **01.06.2022**
(21) Application number: 17774989.2
(22) Date of filing: 27.03.2017
(51) Int. Cl.: H01L 21/56, C09J 7/20, C09J 133/04, C09J 201/00, H01L 23/31

(54) **ADHESIVE FILM FOR USE IN SEMICONDUCTOR DEVICE MANUFACTURING, AND SEMICONDUCTOR DEVICE MANUFACTURING METHOD**
HAFTFOLIE ZUR VERWENDUNG IN DER HALBLEITERBAUELEMENTHERSTELLUNG UND HALBLEITERBAUELEMENTHERSTELLUNGSVERFAHREN
FILM ADHÉSIF DESTINÉ À ÊTRE UTILISÉ DANS LA FABRICATION DE DISPOSITIFS À SEMI-CONDUCTEUR, ET PROCÉDÉ DE FABRICATION DE DISPOSITIFS À SEMI-CONDUCTEUR

(30) Priority: 29.03.2016 JP 2016066439
(43) Date of publication of application: 13.02.2019
(73) Proprietor: Mitsui Chemicals Tohcello, Inc., Tokyo 101-8485 (JP)
(72) Inventor: IGARASHI, Kouji, Nagoya-shi Aichi 457-0801 (JP); MORIMOTO, Akimitsu, Nagoya-shi Aichi 457-0801 (JP); FUKUMOTO, Hideki, Nagoya-shi Aichi 457-0801 (JP)
(74) Representative: Hoffmann Eitle
(86) International application number: PCT/JP2017/012479
(87) International publication number: WO 2017/170452

(56) References cited:
- WO-A1-2017/038921
- WO-A1-2017/038922
- DE-A1- 2 707 931
- JP-A- 2011 129 649
- JP-A- 2013 040 333
- KR-B1- 101 393 701
- KR-B1- 101 393 701
- US-A1- 2013 244 402
- US-A1- 2014 162 407

## Description

### TECHNICAL FIELD

The present invention relates to an adhesive film for temporarily fixing an electronic component in a manufacturing process of a semiconductor device and a method for manufacturing a semiconductor device.

### BACKGROUND ART

As a technology capable of reducing size and weight of a semiconductor device, fan-out wafer-level packaging (WLP) have been developed.

In embedded Wafer Level Ball Grid Array (eWLB), which is one of the methods for manufacturing fan-out WLP, a plurality of electronic components such as semiconductor chips are separated and fixed temporarily on an adhesive film adhered to a supporting substrate and the plurality of electronic components are collectively encapsulated with an encapsulating material. The adhesive film is required to be fixed to the electronic component and the supporting substrate in an encapsulating step. After encapsulating, it is necessary to remove the adhesive film from the electronic component encapsulated with the supporting substrate.

As a technique related to such a method for manufacturing a fan-out WLP, for example, one described in Patent Document 1 (Pamphlet of WO 2014/162951 A1) can be mentioned.

Patent Document 1 discloses a method for manufacturing a semiconductor device including: a laminating step of placing a resin sheet on a temporary electronic component fixing member having an adhesive sheet and a plurality of electronic components disposed on the adhesive sheet; and an encapsulating step of pressing the laminate obtained in the laminating step at 0.03 to 3 MPa to form an encapsulating body having the plurality of electronic components and the resin sheet covering the plurality of electronic components.

Furthermore, DE 27 07 931 A1 describes a process for applying a curable protective lacquer onto semiconductor devices, arranged on a flat base. The semiconductor devices are fixed on an adhesive film on said base, the removable adhesive film comprising a carrier material and an adhesive layer . The adhesive layer may have an adhesive force of 10 to 20 N/25 mm.

US 2014/162407 A1 is inter alia concerned with the encapsulation of a silicon die with an epoxy-based mold material. According to an embodiment, a double-sided tape such as *REVALPHA* by Nitto Denko is used for temporarily fixing the silicon die to a panel.

EP 2 337 065 A1 is inter alia concerned with a heat-resistant adhesive sheet for temporarily adhering semiconductor components to a substrate, the adhesive sheet containing a base material and an adhesive layer. The adhesive layer may contain 20 to 60 wt.% (based on the organic components) of a rubber component and 40 to 80 wt.% of an epoxy resin component.

In US 2013/244402 A1, an adhesive composition is described which includes an acrylic polymer (A), a heat curable resin (B) having unsaturated hydrocarbon group, and a filler (C) having reactive double bond on a surface.

KR 101393701 B1 relates to a fan-out wafer level packaging process which includes a step of taping a double-sided tape on a carrier; a step of arranging a silicon chip on the double-sided tape; and a step of molding the arranged silicon chip with an epoxy molding compound.

### RELATED DOCUMENT

### PATENT DOCUMENT

[Patent Document 1] Pamphlet of WO 2014/162951 A1

### SUMMARY OF THE INVENTION

### TECHNICAL PROBLEM

According to the studies of the present inventors, it is apparent that there are some cases of occurring encapsulating unevenness in the electronic component when the electronic component is disposed on a conventional adhesive film and is encapsulated with the encapsulating material used in the method for manufacturing the fan-out WLP.

The present invention has been made in view of the above described circumstances, and the present invention is to provide an adhesive film for temporarily fixing an electronic component capable of suppressing encapsulating unevenness of the electronic component when encapsulating the electronic component disposed on the adhesive film with the encapsulating material.

### SOLUTION TO PROBLEM

The present inventors have conducted intensive studies to achieve the above object. As a result, the present inventors found that, in an adhesive film including a base material layer and an adhesive resin layer provided on a first surface side of the base material layer and for temporarily fixing an electronic component, surface free energy of a surface of the adhesive resin layer is effective as a design index of the adhesive film for suppressing encapsulating unevenness of the electronic component.

The present inventors have conducted further intensive studies based on such knowledge. As a result, the present inventors also found that encapsulating unevenness of the electronic component can be suppressed by setting the surface free energy of the surface of the adhesive resin layer to equal to or less than a specific value, and completed the present invention.

According to the present invention, there is provided an adhesive film for manufacturing a semiconductor device and a method for manufacturing a semiconductor device as follows.
[1] An adhesive film for temporarily fixing an electronic component when encapsulating the electronic component with an epoxy resin based encapsulating material by compression molding in a manufacturing process of a semiconductor device, the film including:
   a base material layer; and
   an adhesive resin layer (A) provided on a first surface side of the base material layer and for temporarily fixing the electronic component,
   in which surface free energy of the surface of the adhesive resin layer (A) is equal to or more than 20.0 mN/m and equal to or less than 38.0 mN/m.
[2] A method for manufacturing a semiconductor device at least including:
   (A) a step of preparing a structure including an adhesive film and an electronic component temporarily fixed to the adhesive film;
   (B) a step of encapsulating the electronic component with an epoxy resin based encapsulating material by compression molding; and
   (C) a step of removing the adhesive film from the electronic component,
      in which the adhesive film is the adhesive film according to [1].

### ADVANTAGEOUS EFFECTS OF INVENTION

According to the present invention, there is provided an adhesive film for temporarily fixing an electronic component capable of suppressing encapsulating unevenness of the electronic component when encapsulating the electronic component disposed on the adhesive film with the encapsulating material.

### BRIEF DESCRIPTION OF THE DRAWINGS

The above described object and other objects, features, and advantages will become more apparent from the following description of the preferred embodiments and accompanying drawings.
FIG. 1 is a cross-sectional view schematically showing an example of a structure of an adhesive film for manufacturing a semiconductor device according to an embodiment of the present invention.
FIG. 2 is a cross-sectional view schematically showing an example of a structure of an adhesive film for manufacturing a semiconductor device according to an embodiment of the present invention.
FIG. 3 is a cross-sectional view schematically showing an example of the method for manufacturing a semiconductor device according to an embodiment of the present invention.

### DESCRIPTION OF EMBODIMENTS

Hereinafter, embodiments of the present invention will be described with reference to drawings. In all drawings, the same reference numerals are given to the same configuration elements, and the detailed description thereof will not be repeated. Also, the drawings are schematic ones and do not match the actual dimensions. "A to B" in the numerical range represents equal to or more than A and equal to or less than B unless otherwise specified. In the present embodiment, "(meth)acrylic" means acrylic, methacrylic or both acrylic and methacrylic.

### 1. Adhesive film for manufacturing a semiconductor device

First, an adhesive film 50 for manufacturing a semiconductor device according to the present embodiment will be described.

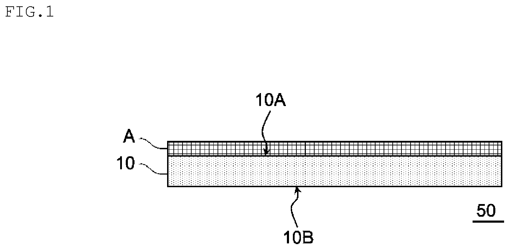

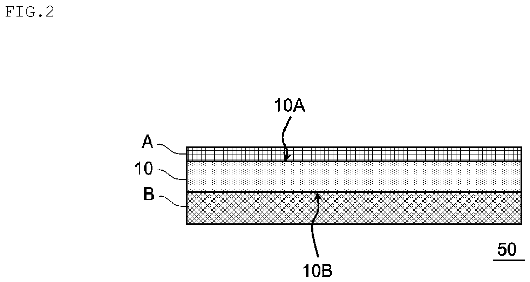

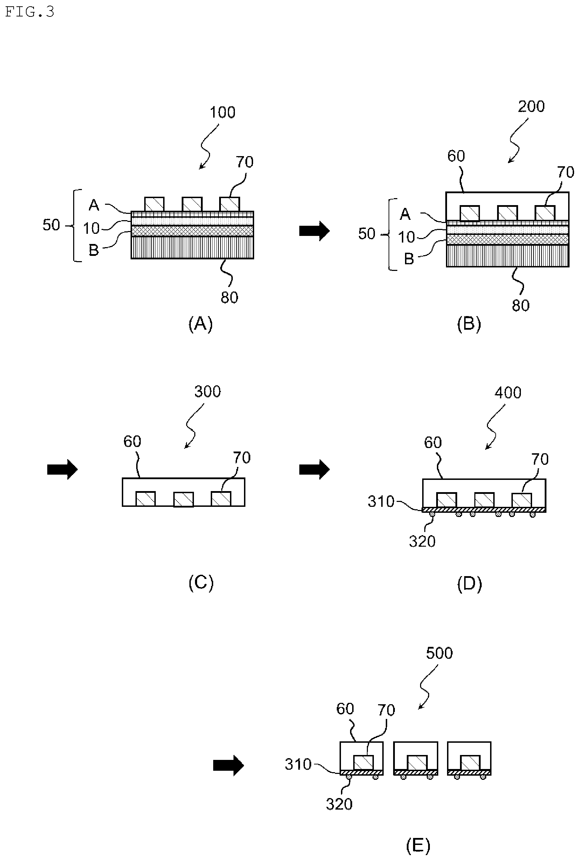

FIGs. 1 and 2 are each a cross-sectional view schematically showing an example of a structure of an adhesive film 50 for manufacturing a semiconductor device according to an embodiment of the present invention. FIG. 3 is a cross-sectional view schematically showing an example of the method for manufacturing a semiconductor device according to an embodiment of the present invention.

As shown in Fig. 1, the adhesive film 50 for manufacturing a semiconductor device (hereinafter also refer to "adhesive film 50") according to the present embodiment is a film used for temporarily fixing an electronic component 70 when encapsulating the electronic component 70 with an encapsulating material 60 in a manufacturing process of a semiconductor device, and includes a base material layer 10, and an adhesive resin layer (A) provided on a first surface 10A side of the base material layer 10 and for temporarily fixing the electronic component 70. Surface free energy of a surface of the adhesive resin layer (A) is equal to or more than 20.0 mN/m and equal to or less than 38.0 mN/m.

As described above, according to the studies of the present inventors, it is apparent that there are some cases of occurring encapsulating unevenness in the electronic component when the electronic component is disposed on a conventional adhesive film and is encapsulated with the encapsulating material in the method for manufacturing the fan-out WLP.

The present inventors have conducted intensive studies to achieve an adhesive film for temporarily fixing an electronic component capable of suppressing encapsulating unevenness of the electronic component when encapsulating the electronic component disposed on the adhesive film with the encapsulating material in a manufacturing process of a semiconductor device. As a result, the present inventors found that, in the adhesive film 50 including the base material layer 10 and the adhesive resin layer (A) provided on the first surface 10A side of the base material layer 10 and for temporarily fixing the electronic component 70, surface free energy of a surface of the adhesive resin layer (A) is effective as a design index for suppressing encapsulating unevenness of the electronic component.

The present inventors have conducted further intensive studies based on such knowledge. As a result, the affinity of the encapsulating material 60 to the adhesive film 50 by setting the surface free energy of the surface of the adhesive resin layer (A) to equal to or more than 20.0 mN/m and equal to or less than 38.0 mN/m. Consequently, the encapsulating material 60 is filled to every corner of the mold, whereby encapsulating unevenness of the electronic component 70 can be suppressed.

That is, the adhesive film 50 for manufacturing a semiconductor device according to the present embodiment enables to suppress encapsulating unevenness of the electronic component 70 by setting the surface free energy of the surface of the adhesive resin layer (A) to equal to or less than the upper limit value when encapsulating the electronic component 70 disposed on the adhesive film 50 with the encapsulating material 60.

Further, the adhesive film 50 for manufacturing a semiconductor device according to the present embodiment enables to prevent adhesive residue from occurring in the electronic component 70 when peeling the adhesive film 50 from the electronic component 70 by setting the surface free energy of the surface of the adhesive resin layer (A) to equal to or less than the upper limit value.

In the adhesive film 50 according to the present embodiment, the surface free energy of the surface of the adhesive resin layer (A) is equal to or less than 38.0 mN/m, preferably equal to or less than 35.0 mN/m, more preferably equal to or less than 33.0 mN/m, particularly preferably equal to or less than 31.0 mN/m. By setting the surface free energy of the surface of the adhesive resin layer (A) to equal to or less than the upper limit value, it is possible to encapsulate the electronic component 70 more evenly when encapsulating the electronic component 70 with the encapsulating material 60 in a manufacturing process of a semiconductor device. Furthermore, by setting the surface free energy of the surface of the adhesive resin layer (A) to equal to or less than the upper limit value, it is possible to further suppress adhesive residue on the electronic component 70 when peeling the adhesive film 50 from the electronic component 70.

The lower limit value of the surface free energy of the surface of the adhesive resin layer (A) is equal to or more than 20.0 mN/m from the viewpoint of improving adhesive force of the surface of the adhesive resin layer (A), preferably equal to or more than 25.0 mN/m.

The surface free energy of the surface of the adhesive resin layer (A) can be controlled within the above range, for example, by appropriately controlling a polar component and a hydrogen bonding component among components of the surface free energy.

The surface free energy (γ) is composed of three components: a dispersion component (γa), a polar component (γb) and a hydrogen bonding component (γc). That is, a sum of these three components corresponds to the surface free energy (γ) (=γa+γb+γc). This is described in the Japan Adhesion Society Journal No. 8(3), 131-141 (1972), and is also referred to as the Extended Fowkes Theory.

The respective components of the surface free energy (dispersion component (γa), polar component (γb), and hydrogen bonding component (γc)) can be determined by an automatic contact angle gauge. As the automatic contact angle gauge, for example, CA-V type gauge manufactured by Kyowa Interface Science can be adopted. In particular, distilled water, diiodomethane, and 1-bromonaphthalene, each of which had a known contact angle, are dropped on the surface of the adhesive resin layer (A), and the contact angle of each droplet is measured 1 second after the dropwise addition. Each component of the surface free energy of the surface of the adhesive resin layer (A) is calculated. This calculation can be performed referring to a method described in "Nara Prefectural Industrial Technology Center, Research Report No.26, 2000)", pages 1 to 2.

In the present embodiment, for example, by appropriately adjusting (1) type or proportion of each component constituting the adhesive resin layer (A), (2) type or content ratio of each monomer in an adhesive resin constituting the adhesive resin layer (A), the surface free energy of the surface of the adhesive resin layer (A) can be controlled within the aforementioned range.

Among these, for example, type and proportion of a surfactant in the adhesive resin layer (A), type and proportion of an initiator in the adhesive resin layer (A), and type and content ratio of a polar monomer in the adhesive resin constituting the adhesive resin layer (A) are considered as elements for setting the surface free energy of the surface of the adhesive resin layer (A) to fall within a desired numerical value range.

For example, the surface free energy of the surface of the adhesive resin layer (A) is lowered by reducing the contents of surfactant, polymerization initiator and polar monomer in adhesive resin in the adhesive resin layer (A).

The polar monomer in the adhesive resin is exemplified as a monomer having a hydroxyl group or a carboxyl group.

In the adhesive film 50 according to the present embodiment, a resin-spreading ratio at 150°C measured by the following method is preferably equal to or more than 8%, more preferably equal to or more than 9%, still more preferably equal to or more than 10%.

The affinity of the encapsulating material 60 to the adhesive film 50 is further improved by setting the resin-spreading ratio of the adhesive film 50 to equal to or more than the lower limit value. Consequently, the encapsulating material 60 can be filled to every corner of the mold more evenly, thus the electronic component 70 can be encapsulated more uniformly.

### (Method)

An epoxy resin based encapsulating material with a diameter of 2 mm and a thickness of 130 µm is applied to a surface of the adhesive resin layer (A). The applied layer is left at 23°C for 1 minute and then heated at 150°C for 5 minutes to cure the epoxy resin based encapsulating material. An area of the cured epoxy resin based encapsulating material is measured. The resin-spreading ratio at 150°C is calculated as 100 x (X₁-X₀) /X₀ when an area of the epoxy resin based encapsulating material immediately after applied on the adhesive resin layer (A) is X₀ and the area of the cured epoxy resin based encapsulating material is X₁.

Epoxy resin based encapsulating materials containing epoxy resin as a main component can be adopted as the epoxy resin based encapsulating material used for the measurement of the resin-spreading ratio. For example, T693/R4212 manufactured by Nagase Chemtex can be used.

The total thickness of the adhesive film 50 according to the present embodiment is preferably equal to or more than 10 µm and equal to or less than 1000 µm, more preferably equal to or more than 20 µm and equal to or less than 500 µm, with consideration of balance of mechanical properties and handling properties.

The adhesive film 50 according to the present embodiment can be used in a film for temporarily fixing an electronic component in a manufacturing process of a semiconductor device, and in particular, can be used suitably as a film for temporarily fixing an electronic component in a manufacturing process of a fan-out WLP.

Next, respective layers constituting the adhesive film 50 for manufacturing a semiconductor device according to the present embodiment will be described.

### <Base material layer>

The base material layer 10 is a layer provided for the purpose of further improving properties such as handleability, mechanical properties, and heat resistance of the adhesive film 50.

The base material layer 10 is not particularly limited, however, a resin film can be exemplified as the base material layer 10.

As a resin constituting the above-mentioned resin film, well-known thermoplastic resins can be used. Examples of the resin include one or two more selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, and polymetaxylene adipamide; polyacrylate; polymethacrylate; polyvinyl chloride; polyvinylidene chloride; polyimide; polyether imide; ethylene-vinyl acetate copolymer; polyacrylonitrile; polycarbonate; polystyrene; aionomer; polysulfone; polyethersulfone; and polyphenylene ether.

Among them, one or two or more selected from the group consisting of polypropylene, polyethylene phthalate, polyethylene naphthalate, polyamide and polyimide are preferable from the viewpoint of excellent balance of transparency, mechanical strength, and price. One or two or more selected from the group consisting of polyethylene phthalate and polyethylene naphthalate are more preferable.

The base material layer 10 may be single layered or two or more layered.

The form of the resin film used for forming the base material layer 10 may be a stretched film or a film stretched in a uniaxial direction or biaxial direction, and it is preferable that the film be stretched in the uniaxial direction or the biaxial direction from the viewpoint of improving the mechanical strength of the base material layer 10.

The thickness of the base material layer 10 is preferably equal to or more than 1 µm and equal to or less than 500 µm, more preferably equal to or more than 5 µm and equal to or less than 300 µm, still more preferably equal to or more than 10 µm and equal to or less than 250 µm, from the viewpoint of obtaining favorable film characteristics.

The base material layer 10 may be subjected to a surface treatment in order to improve the adhesiveness to other layers. Specifically, corona treatment, plasma treatment, undercoat treatment, or primer coating treatment may be performed.

### <Adhesive resin layer (A)>

The adhesive resin layer (A) is a layer provided on one surface side of the base material layer 10, and a layer for temporarily fixing the electronic component 70 in contact with the surface of the electronic component 70 when encapsulating the electronic component 70 with the encapsulating material 60 in a manufacturing process of a semiconductor device.

Examples of the adhesive constituting the adhesive resin layer (A) include a (meth) acrylic adhesive, a silicone adhesive, a urethane adhesive, an olefin adhesive, and a styrene adhesive.

Here, the (meth)acrylic adhesive contains a (meth)acrylic adhesive resin as an essential component. The silicone adhesive contains a silicone adhesive resin as an essential component. The urethane adhesive contains a urethane adhesive resin an essential component.

Among them, a (meth)acrylic adhesive is preferable from the viewpoint of facilitating adjustment of adhesive force.

As the adhesive constituting the adhesive resin layer (A), a radiation-crosslinking type adhesive which reduces the adhesive force by radiation can be used. The adhesive resin layer (A) composed of the radiation-crosslinking type adhesive is crosslinked by irradiation of radiation, and thus adhesive force is remarkably decreased. Consequently, the adhesive film 50 is easily peeled from the electronic component 70. As the radiation, ultraviolet rays, electron beams, and infrared rays can be mentioned.

As the radiation-crosslinking type adhesive, an ultraviolet-crosslinking type adhesive is preferable.

Examples of the (meth)acrylic adhesive resin used in the (meth) acrylic adhesive include a copolymer including a (meth) acrylic acid alkyl ester monomer unit (A) and a monomer unit (B) having a functional group capable of reacting with a crosslinking agent.

In the present embodiment, the (meth)acrylic acid alkyl ester means an acrylic acid alkyl ester, a methacrylic acid alkyl ester, or a mixture thereof.

The (meth)acrylic adhesive resin according to the present embodiment can be obtained by copolymerizing a monomer mixture containing a (meth) acrylic acid alkyl ester monomer (A) and a monomer (B) having a functional group capable of reacting with a crosslinking agent.

As the monomer (A) forming the (meth)acrylic acid alkyl ester monomer unit (A), (meth) acrylic acid alkyl ester having an alkyl group having about 1 to 12 carbon atoms can be mentioned. (Meth)Acrylic acid alkyl ester having an alkyl group having 1 to 8 carbon atoms is preferable. Specifically, examples thereof include methyl acrylate, methyl methacrylate, ethyl acrylate, ethyl methacrylate, butyl acrylate, butyl methacrylate, 2-ethylhexyl acrylate, and 2-ethylhexyl methacrylate. These may be used singly, or two or more thereof may be used.

In the (meth)acrylic adhesive resin according to the present embodiment, the content of the (meth) acrylic acid alkyl ester monomer unit (A) is preferably equal to or more than 10% by mass and equal to or less than 98.9% by mass, and more preferably equal to or more than 85 mass% and equal to or less than 95 mass%, with respect to the total of all the monomer units in the (meth) acrylic adhesive resin as 100% by mass.

As the monomer (B) forming the monomer (B) having a functional group capable of reacting with the crosslinking agent, acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylate, acrylamide, methacrylamide, tert-butylaminoethyl acrylate, and tert-butylaminoethyl methacrylate. Acrylic acid, methacrylic acid, 2-hydroxyethyl acrylate, 2-hydroxyethyl methacrylate, acrylamide, and methacrylamide are preferable. These may be used singly, or two or more thereof may be used.

In the (meth)acrylic adhesive resin according to the present embodiment, the content of the monomer unit (B) is preferably equal to or more than 1% by mass and equal to or less than 40% by mass, more preferably equal to or more than 1% by mass and equal to or less than 20% by mass, and still more preferably equal to or more than 1% by mass and equal to or less than 10% by mass, with respect to the total of all the monomer units in the (meth) acrylic adhesive resin as 100% by mass.

In addition to the monomer unit (A) and the monomer unit (B), the (meth) acrylic adhesive resin according to the present embodiment may further contain a bifunctional monomer (C) or a specific comonomer having properties as a surfactant (hereinafter referred to as polymerizable surfactant) unit.

The polymerizable surfactant has a property of being copolymerized with the monomer (A), the monomer (B), and the monomer (C), and acts as an emulsifier in a case of emulsion polymerization.

Examples of the monomer (C) forming the bifunctional monomer unit (C) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di (meth) acrylate and ones in which with diacrylate or dimethacrylate at both ends, the main chain has propylene glycol type structure (for example, manufactured by NOF Corporation, trade name: PDP-200, PDP-400, ADP-200, ADP-400), tetramethylene glycol type structure (for example, manufactured by NOF Corporation, trade name: ADT-250 and ADT-850), and mixed type thereof (for example, manufactured by NOF Corporation, trade name: ADET-1800, ADPT-4000).

In the (meth)acrylic adhesive resin according to the present embodiment, the content of the monomer unit (C) is preferably equal to or more than 0.1% by mass and equal to or less than 30% by mass, more preferably equal to or more than 0.1% by mass to equal to or less than 5% by mass, with respect to the total of all the monomer units in the (meth)acrylic adhesive resin as 100% by mass.

Examples of the polymerizable surfactant include those obtained by introducing polymerizable 1-propenyl group to the benzene ring of polyoxyethylene nonylphenyl ether (for example, manufactured by DKS Co. Ltd., trade name: Aqualon RN-10, RN-20, RN-30, and RN-50), those obtained by introducing polymerizable 1-propenyl group into the benzene ring of an ammonium salt of sulfuric acid ester of polyoxyethylene nonylphenyl ether (for example, manufactured by DKS Co. Ltd., trade name: Aqualon HS-10, HS-20, and HS-1025), and sulfosuccinic acid diester having a polymerizable double bond in the molecule (for example, manufactured by Kao Corporation trade name: Latemul S-120A, and S-180A).

The (meth)acrylic adhesive resin according to the present embodiment may contain a monomer unit formed of a monomer having a polymerizable double bond such as vinyl acetate, acrylonitrile, and styrene if necessary.

Examples of the polymerization reaction mechanism of the (meth)acrylic adhesive resin according to the present embodiment include radical polymerization, anionic polymerization, and cationic polymerization. Considering the production cost of the (meth)acrylic adhesive resin, the influence of the functional group of the monomer and the influence of ion exerted on the surface of the electronic component 70, it is preferable to polymerize by radical polymerization.

In a case of the polymerization by a radical polymerization reaction, examples of radical polymerization initiator include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butyl peroxy phthalate, t-butyl peroxybenzoate, di-t-butyl peroxyacetate, t-butyl peroxy isobutylate, t-butyl peroxy-2-hexanoate, t-butyl peroxy-2-ethyl hexanoate, t-butyl peroxy-3,5,5-trimethyl hexanoate, acetyl peroxide, isobutyryl peroxide, octanoyl peroxide, t-butyl peroxide and di-t-amyl peroxide; inorganic peroxides such as ammonium persulfate, potassium persulfate, and sodium persulfate; and azo compounds such as 2,2'-azobisisobutyronitrile, 2,2'-azobis-2-methylbutyronitrile, and 4,4'-azobis-4-cyanovaleric acid.

In a case of emulsion polymerization, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic component 70, ammonium persulfate and the azo compounds having a carboxyl group in the molecule such as 4,4'-azobis-4-cyanovaleric acid are more preferable, and the azo compounds having a carboxyl group in the molecule such as 4,4'-azobis-4-cyanovaleric acid are particularly preferable.

In addition to the (meth)acrylic adhesive resin, the (meth)acrylic adhesive preferably further contains a crosslinking agent having two or more crosslinking functional groups in one molecule.

A crosslinking agent having two or more crosslinking functional groups in one molecule is used for reacting with a functional group of the (meth) acrylic adhesive resin and adjusting the adhesive force and the cohesive force.

Examples of such a crosslinking agent include epoxy compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcin diglycidyl ether; isocyanate compounds such as tetramethylene diisocyanate, hexamethylene diisocyanate, tolylene diisocyanate 3 adduct of trimethylol propane, polyisocyanate, diphenylmethane diisocyanate, and tolylene diisocyanate; aziridine compounds such as trimethylolpropane tri-β-aziridinyl propionate, tetramethylolmethane-tri-β-aziridinyl propionate, N,N'-diphenylmethane-4,4'-bis (1-aziridinecarboxamide), N,N'-hexamethylene-1,6-bis (1-aziridinecarboxamide), N,N'-toluene-2,4-bis (1-aziridinecarboxamide), and trimethylolpropane-β-(2-methylaziridine) propionate; tetrafunctional epoxy compounds such as N,N,N',N'-tetraglycidyl-m-xylenediamine and 1,3-bis (N,N'-diglycidylaminomethyl) cyclohexane; and melamine compounds such as hexamethoxymethylol melamine. These may be used singly, or in combination of two or more thereof.

Among these, it is preferable that one or two or more selected from the group consisting of an epoxy compound, a tetrafunctional epoxy compound, an isocyanate compound, and an aziridine compound be contained.

The content of the crosslinking agent is usually preferably in the range such that the number of functional groups in the crosslinking agent is not larger than the number of functional groups in the (meth) acrylic adhesive resin. However, in a case where a new functional group is generated in the crosslinking reaction, or in a case where the crosslinking reaction is slow, it may be contained in excess if necessary.

The content of the crosslinking agent in the (meth)acrylic adhesive is preferably equal to or more than 0.1 parts by mass and equal to or less than 15 parts by mass, with respect to 100 parts by mass of the (meth)acrylic adhesive resin from the viewpoint of improving the balance with heat resistance and adhesive force of the adhesive resin layer (A).

The ultraviolet-crosslinking type adhesive according to the present embodiment preferably further contains an ultraviolet polymerization initiator in addition to the adhesive resin. In doing so, the curing time and ultraviolet radiation dose by ultraviolet radiation can be reduced.

Examples of ultraviolet polymerization initiators include acetophenone based photopolymerization initiators such as methoxy acetophenone, α-ketol compounds such as 4-(2-hydroxyethoxy) phenyl (2-hydroxy-2-propyl) ketone; ketal compounds such as benzyl dimethyl ketal; benzoin based photopolymerization initiators such as benzoin, benzoin methyl ether, benzoin ethyl ether, and benzoin isopropyl ether; and benzophenone based photopolymerization initiators such as benzophenone and benzoyl benzoic acid.

The content of the ultraviolet polymerization initiator in the ultraviolet-crosslinking type adhesive is preferably equal to or more than 0.1 part by mass and equal to or less than 10 parts by mass, more preferably equal to or more than 2.5 parts by mass and equal to or less than 5 parts by mass with respect to 100 parts by mass of the adhesive resin.

The thickness of the adhesive resin layer (A) is not particularly limited, and preferably equal to or more than 1 µm and equal to or less than 100 µm, more preferably equal to or more than 3 µm and equal to or less than 50 µm, for example.

The adhesive resin layer (A) may be formed, for example, by applying an adhesive on the base material layer 10. The adhesive may be dissolved in a solvent and applied as a coating solution, may be applied as an aqueous emulsion, or may be directly applied with a liquid adhesive.

As the aqueous emulsion, an acrylic resin emulsion can be suitably used.

In a case of using an adhesive coating solution dissolved in an organic solvent, the organic solvent is not particularly limited, and may be appropriately selected from publicly known considering solubility and drying time. Examples of the organic solvent include esters such as ethyl acetate and methyl acetate; ketones such as acetone and MEK; aromatic solvents such as benzene, toluene, and ethylbenzene; linear or cyclic aliphatic solvents such as heptane, hexane, and cyclohexane; and alcohols such as isopropanol and butanol. As the organic solvent, ethyl acetate and toluene are preferable. These may be used singly, or in combination of two or more thereof.

As a method for applying the adhesive coating solution, coating methods in the known related art such as a roll coater method, a reverse roll coater method, a gravure roll method, a bar coat method, a comma coater method, and a die coater method can be adopted. The drying condition of the applied adhesive is not particularly limited, and it is typically preferable to dry in the temperature range of 80°C to 200°C for 10 seconds to 10 minutes. It is more preferable to dry at 80 °C to 170 °C for 15 seconds to 5 minutes. In order to sufficiently accelerate the crosslinking reaction between the crosslinking agent and the adhesive, heating may be performed at 40 °C to 80 °C for about 5 to 300 hours after the drying of the adhesive coating solution is completed.

Further, the base material layer 10 and the adhesive resin layer (A) may be prepared by coextrusion molding, or the film-shaped base material layer 10 and the film-shaped adhesive resin layer (A) may be prepared by laminating one another.

Next, a method for manufacturing an adhesive film 50 according to the present embodiment will be described.

The adhesive film 50 according to the present embodiment is different from one obtained by the conventional manufacturing method, and it is necessary to precisely control the manufacturing conditions. That is, the adhesive film 50 of which surface free energy on the surface of the aforementioned adhesive resin layer (A) satisfies the aforementioned specific conditions is obtained for the first time by a manufacturing method precisely controlling various factors relating to the following two conditions.
(1) type or proportion of each component constituting the adhesive resin layer (A); and
(2) type or content ratio of each monomer in an adhesive resin constituting the adhesive resin layer (A).

However, on the premise that the various factors relating to the aforementioned two conditions are precisely controlled, the adhesive film 50 according to the present embodiment can adopt various kinds of specific manufacturing conditions such as temperature setting of the manufacturing apparatus. In other words, the adhesive film 50 according to the present embodiment can be manufactured by using a known method, except that various factors relating to the above two conditions are precisely controlled. Next, an example of a method for manufacturing the adhesive film 50 according to the present embodiment will be described on the premise that various factors relating to the above two conditions are precisely controlled.

An adhesive coating solution is applied onto the base material layer 10 and dried, whereby the adhesive resin layer (A) is formed, and an adhesive film 50 is obtained.

Further, the base material layer 10 and the adhesive resin layer (A) may be prepared by coextrusion molding, or the film-shaped base material layer 10 and the film-shaped adhesive resin layer (A) may be prepared by laminating one another.

### <Adhesive resin layer (B)>

The adhesive film 50 according to the present embodiment may further include an adhesive resin layer (B) provided on a second surface 10B side opposite to the first surface 10A of the base material layer 10, of which adhesive force is lowered by external stimulus.

Thus, the adhesive film 50 can be more easily peeled from a supporting substrate 80 by applying external stimulus.

Examples of the adhesive resin layer (B) of which adhesive force is lowered by external stimulus include a heat-peelable adhesive resin layer of which adhesive force is lowered by heating, and a radiation- peelable adhesive resin layer of which adhesive force decreases due to radiation.

The heat-peelable adhesive resin layer (B) is, for example, an adhesive resin layer capable of reducing the adhesive force by heating.

Examples of the heat-peelable adhesive resin layer (B) include an adhesive resin layer composed of a thermally expandable adhesive which can be expanded by heating to reduce the adhesive force.

Examples of the thermally expandable adhesive include a thermally expandable adhesive containing a gas generating component, a thermally expandable adhesive containing thermally expandable microspheres capable of reducing the adhesive force by expanding, and a thermally expandable adhesive of which adhesive force can be reduced by crosslinking reaction of an adhesive component due to heat.

In the present embodiment, the thermally expandable adhesive used in the heat-peelable adhesive resin layer (B) is an adhesive of which adhesive force is reduced or lost by heating. For example, it is possible to select a material which does not peel off at 150°C or less but peels at a temperature exceeding 150°C. It is preferable that the thermally expandable adhesive has adhesive force such that the adhesive film 50 does not peel from the supporting substrate 80 in a manufacturing process of a semiconductor device.

Examples of the thermally expandable adhesive used in the heat-peelable adhesive resin layer (B), an adhesive containing a gas generating component and an adhesive resin, and an adhesive containing heat expandable microspheres and an adhesive resin.

Examples of the gas generating component used in the thermally expandable adhesive include an azo compound, an azide compound, and Meldrum's acid derivative. Furthermore, inorganic foaming agents such as ammonium carbonate, ammonium hydrogen carbonate, sodium hydrogencarbonate, ammonium nitrite, sodium borohydride and various azides; water; chlorofluorinated alkane compounds such as trichloromonofluoromethane and dichloromonofluoromethane; azo compounds such as azobisisobutyronitrile, azodicarbonamide, and barium azodicarboxylate; hydrazine compounds such as p-toluenesulfonyl hydrazide, diphenyl sulfone-3,3'-disulfonyl hydrazide, 4,4'-oxybis (benzene sulfonyl hydrazide), and allylbis (sulfonyl hydrazide); semicarbazide-based compounds such as p-toluylene sulfonyl semicarbazide and 4,4'-oxybis (benzenesulfonyl semicarbazide); triazole compounds such as 5-morpholyl-1,2,3,4-thiatriazole; and organic foaming agents such as N-nitroso compounds, such as N,N'-dinitrosopentamethylenetetramine and N,N'-dimethyl-N,N'-dinitrosoterephthalamide, can be used. The gas generating component may be added to the adhesive resin or may be directly bonded to the adhesive resin.

As the thermally expandable microspheres used for the thermally expandable adhesive, a material in which a substance which is gasified and exhibits thermally expandable property is enclosed in a shell forming substance can be used. More specifically, microencapsulated blowing agents can be used. As the thermally expandable microspheres, for example, microspheres in which a material that can be easily gasified and expanded by heating such as isobutane, propane, or pentane is enclosed in an elastic shell can be mentioned. Examples of the material constituting the shell include vinylidene chloride-acrylonitrile copolymer, polyvinyl alcohol, polyvinyl butyral, polymethyl methacrylate, polyacrylonitrile, polyvinylidene chloride, and polysulfone. The thermally expandable microspheres can be produced, for example, by a coacervation method or an interfacial polymerization method.

The thermally expandable microspheres can be added to the adhesive resin.

The content of at least one selected from the gas generating component and the thermally expandable microspheres may be appropriately set according to the expansion magnification or the adhesive force lowering property of the heat-peelable adhesive resin layer (B). However, it is not particularly limited. For example, the content is equal to or more than 1 part by mass and equal to or less than 150 parts by mass, preferably equal to or more than 10 parts by mass and equal to or less than 130 parts by mass, more preferably equal to or more than 25 parts by mass and equal to or less than 100 parts by mass with respect to 100 parts by mass of the adhesive resin in the heat-peelable adhesive resin layer (B).

It is preferable to design so that the temperature at which the gas is generated or the temperature at which the thermally expandable microspheres thermally expand is a temperature exceeding 150°C.

It is preferable to design so that the temperature at which the gas is generated or the temperature at which the thermally expandable microspheres thermally expand is a temperature exceeding 150°C.

Examples of the adhesive resin constituting the thermally expandable adhesive include (meth)acrylic resin, urethane resin, silicone resin, polyolefin resin, polyester resin, polyamide resin, fluorine resin, and styrene-dienes block copolymer-based resin. Among these, (meth)acrylic resin is preferable.

In the adhesive film 50 according to the present embodiment, from the viewpoint of stably holding the electronic component on the adhesive resin layer (A) when peeling the supporting substrate from the adhesive resin layer (B) by reducing the adhesive force of the adhesive resin layer (B) by applying an external stimulus, the content of at least one selected from the gas generating component and the thermally expandable microspheres in the adhesive resin layer (A) is preferably equal to or less than 0.1% by mass, more preferably equal to or less than 0.05% by mass, and still more preferably equal to or less than 0.01% by mass, based on 100% by mass of the whole adhesive resin layer (A). It is particularly preferable that at least one selected from the gas generating component and the thermally expanding microspheres is not contained in the adhesive resin layer (A) .

The thickness of the adhesive resin layer (B) is not particularly limited, and preferably equal to or more than 5 µm and equal to or less than 300 µm, more preferably equal to or more than 20 µm and equal to or less than 150 µm, for example.

The adhesive resin layer (B) may be formed, for example, by applying an adhesive coating solution on the base material layer 10.

As a method for applying the adhesive coating solution, coating methods in the known related art such as a roll coater method, a reverse roll coater method, a gravure roll method, a bar coat method, a comma coater method, and a die coater method can be adopted. The drying condition of the applied adhesive is not particularly limited, and it is typically preferable to dry in the temperature range of 80°C to 200°C for 10 seconds to 10 minutes. It is more preferable to dry at 80°C to 170°C for 15 seconds to 5 minutes. In order to sufficiently accelerate the crosslinking reaction between the crosslinking agent and the adhesive, heating may be performed at 40°C to 80°C for about 5 to 300 hours after the drying of the adhesive coating solution is completed.

Further, the base material layer 10 and the adhesive resin layer (B) may be prepared by coextrusion molding, or the film-shaped base material layer 10 and the film-shaped adhesive resin layer (B) may be prepared by laminating one another.

### (Other layers)

The adhesive film 50 according to the present embodiment may be additionally provided with an unevenness absorbing layer, a shock absorbing layer, or an easy adhesion layer, between the base material layer 10 and the adhesive resin layer (A), or between the base material layer 10 and the adhesive resin layer (B), within a range that does not impair the effect of the present embodiment.

### 2. Method for manufacturing semiconductor device

Next, a method for manufacturing a semiconductor device according to the present embodiment will be described.

The method for manufacturing a semiconductor device according to the present embodiment includes at least the following three steps:
(A) a step of preparing a structure 100 including an adhesive film 50 and an electronic component 70 temporarily fixed to the adhesive film 50;
(B) a step of encapsulating the electronic component 70 with an epoxy resin based encapsulating material 60 by compression molding; and
(C) a step of removing the adhesive film 50 from the electronic component 70.

In the method for manufacturing a semiconductor device according to the present embodiment, the adhesive film 50 for a semiconductor device according to the aforementioned present embodiment is used as the adhesive film for temporarily fixing the electronic component 70.

Next, each step of the method for manufacturing a semiconductor device according to the present embodiment will be described.

### (Step (A))

First, a structure 100 including an adhesive film 50 and an electronic component 70 temporarily fixed to the adhesive film 50 is prepared.

The structure 100 may be produced by, for example, the following procedure.

First, the adhesive film 50 is attached onto a supporting substrate 80 such that the adhesive resin layer (B) is on the supporting substrate 80 side. A protective film may be attached on the adhesive resin layer (B). The protective film can be peeled off and an exposed surface of the adhesive resin layer (B) can be attached to a surface of the supporting substrate 80.

As the supporting substrate 80, for example, a quartz substrate, a glass substrate, or an SUS substrate can be used.

Next, the structure 100 can be obtained by disposing the electronic component 70 on the adhesive resin layer (A) of the adhesive film 50 attached on the supporting substrate 80.

Examples of the electronic component 70 include a semiconductor chip such as an IC, an LSI, a discrete, a light emitting diode, and a light receiving element, a semiconductor panel, and a semiconductor package.

### (Step (B))

Next, the electronic component 70 is encapsulated with the encapsulating material 60.

The electronic component 70 is covered by the encapsulating material 60, and the encapsulating material 60 is cured at, for example, a temperature of 150°C or lower to encapsulate the electronic component 70.

The encapsulating material 60 is an epoxy resin based encapsulating material containing an epoxy resin as a main component can be used. In particular, a liquid epoxy resin based encapsulating material is preferable from the viewpoint that affinity of the encapsulating material 60 to the adhesive film 50 becomes better and the electronic component 70 can be encapsulated more evenly.

As such an epoxy resin based encapsulating material, for example, T693/R4000 series, T693/R1000 series, and T693/R5000 series manufactured by Nagase Chemtex can be used.

The encapsulating method is compression molding. After the electronic component 70 is encapsulated with the encapsulating material 60, the encapsulating material 60 is cured by heating at a temperature of, for example, 150°C or lower, so that a structure 200 in which the electronic component 70 is encapsulated is obtained.

Since the adhesive film 50 according to the present embodiment has a good affinity with the encapsulating material 60, in a case where the adhesive film 50 is used as the adhesive film for temporarily fixing the electronic component 70, in-flow resistance of the encapsulating material 60 decreases, and the encapsulating material 60 can be filled up to every corner in the mold.

Therefore, by using the adhesive film 50 according to the present embodiment, it is possible to suppress the encapsulating unevenness of the electronic component 70 even in a case of encapsulating by compression molding which is likely to cause filling unevenness of the encapsulating material. In particular, it is possible to fill the encapsulating material 60 in a corner of a rectangular panel shape at which compression molding is not good, and it is possible to satisfactorily encapsulate the electronic component 70 even with such a shape.

### (Step (C))

Next, the adhesive film 50 is removed from the electronic component 70 to obtain a semiconductor device 300.

It is preferable to remove the adhesive film 50 after removing the supporting substrate 80.

The supporting substrate 80 is peeled from the adhesive resin layer (B), for example, by reducing adhesive force of the adhesive resin layer (B) by applying external stimulus. After the electronic component 70 is encapsulated, the supporting substrate 80 is heated at a temperature exceeding 150°C to reduce the adhesive force of the heat-peelable adhesive resin layer (B), whereby the adhesive film 50 can be easily removed.

Examples of a method for removing the adhesive film 50 from the electronic component 70 include a method of mechanically peeling off, and a method of peeling after reducing adhesive force of the surface of the adhesive film 50.

### (Step (D))

The method for manufacturing a semiconductor device according to the present embodiment may further include (D) a step of forming a wiring layer 310 and a bump 320 on an exposed surface of the obtained semiconductor device 300 to obtain a semiconductor device 400.

The wiring layer 310 includes a pad (not shown) which is an external connection terminal formed on an outermost surface and a wiring (not shown) which electrically connects the exposed electronic component 70 and the pad. The wiring layer 310 can be formed by a conventionally known method and may have a multilayer structure.

The bump 320 is formed on the pad of the wiring layer 310, and the semiconductor device 400 can be obtained. Examples of the bump 320 include a solder bump or a gold bump. The solder bump can be formed, for example, by placing a solder ball on the pad which is an external connection terminal of the wiring layer 310 and heating to melt (reflow) the solder. The gold bump can be formed by a method such as a ball bonding method, a plating method, or an Au ball transfer method.

### (Step (E))

The method for manufacturing a semiconductor device according to the present embodiment may further include (E) a step of dicing the semiconductor device 400 to obtain a plurality of semiconductor devices 500.

Dicing of the semiconductor device 400 can be performed by a publicly known method.

### [Examples]

Hereinafter, the present invention will be specifically described with reference to Examples, but the present invention is not limited thereto.

Details of the materials used for producing the adhesive film are as follows.

### <Adhesive resin solution 1>

0.5 parts by mass of 4,4'-azobis-4-cyanovaleric acid (manufactured by Otsuka Chemical, trade name: ACVA) as a polymerization initiator, 74.3 parts by mass of n-butyl acrylate and 13.7 parts by mass of methyl methacrylate as monomers (A), 9 parts by mass of 2-hydroxyethyl methacrylate as a monomer (B), and 3 parts by mass of a product obtained by introducing a polymerizable 1-propenyl group into a benzene ring of an ammonium salt of sulfuric acid ester of polyoxyethylene nonylphenyl ether as a polymerizable surfactant (manufactured by DKS Co. Ltd., trade name: Aqualon HS-1025) were respectively added to deionized pure water. Emulsion polymerization was carried out at 70 to 72°C for 8 hours under stirring to obtain an acrylic resin emulsion. The resultant emulsion was neutralized with aqueous ammonia (pH = 7.0) to obtain an adhesive resin solution 1 having a solid content concentration of 42.5%.

### <Adhesive resin solution 2>

0.5 parts by mass of ammonium persulfate as a polymerization initiator, 63 parts by mass of 2-ethylhexyl acrylate, 21 parts of mass of n-butyl acrylate and 9 parts by mass of methyl methacrylate as monomers (A), 3 parts by mass of 2-hydroxyethyl methacrylate as monomers (B), 1 part by mass of polytetramethylene glycol diacrylate (trade name: ADT-250, manufactured by NOF Corporation) as a monomer (C), and 2 parts by mass of a product obtained by introducing a polymerizable 1-propenyl group into a benzene ring of an ammonium salt of sulfuric acid ester of polyoxyethylene nonylphenyl ether as a polymerizable surfactant (manufactured by DKS Co. Ltd., trade name: Aqualon HS-1025) were respectively added to deionized pure water. Emulsion polymerization was carried out at 70 to 72°C for 8 hours under stirring to obtain an acrylic resin emulsion. The resultant emulsion was neutralized with aqueous ammonia (pH = 7.0) to obtain an adhesive resin solution 2 having a solid content concentration of 56.5%.

### <Adhesive resin solution 3>

0.5 parts by mass of 4,4'-azobis-4-cyanovaleric acid (manufactured by Otsuka Chemical, trade name: ACVA) as a polymerization initiator, 47 parts of mass of n-butyl acrylate and 21.5 parts by mass of methyl methacrylate as monomers (A), and 9 parts by mass of 2-hydroxyethyl methacrylate, 7.5 parts by mass of acrylamide and 15 parts by mass of methacrylic acid as monomers (B) were respectively added to deionized pure water. Emulsion polymerization was carried out at 70 to 72°C for 8 hours under stirring to obtain an acrylic resin emulsion. The resultant emulsion was neutralized with aqueous ammonia (pH = 7.0) to obtain an adhesive resin solution 3 having a solid content concentration of 42.5%.

### <Adhesive resin solution 4>

0.266 parts by mass of t-butylperoxy-2-ethylhexanoate (manufactured by NOF Corporation, trade name: PERBUTYL O (registered trademark)) as a polymerization initiator, 72 parts by mass of n-butyl acrylate and 18 parts by mass of methyl methacrylate as monomers (A), and 7 parts by mass of 2-hydroxyethyl methacrylate and 3 parts by mass of acrylic acid as monomer (B) were respectively added to a mixed solvent containing ethyl acetate and toluene. Emulsion polymerization was carried out at 83 to 87°C for 11 hours under stirring to obtain an acrylic resin emulsion having a solid content concentration of 45% as an adhesive resin solution 4.

### <Adhesive coating solution 1>

57.4 parts by mass of the adhesive resin solution 1, 42.6 parts by mass of the adhesive resin solution 2, 0.4 parts by mass of dimethylethanolamine, and 9.3 parts by mass of an epoxy compound (manufactured by Nagase Chemtex, Ex-1610) as a crosslinking agent were mixed together to obtain an adhesive coating solution 1.

### <Adhesive coating solution 2>

100 parts by mass of the adhesive resin solution 1, 1 part by mass of the adhesive resin solution 3, 0.3 part by mass of dimethylethanolamine, and 7 parts by mass of an epoxy compound (manufactured by Nagase Chemtex, Ex-1610) as a crosslinking agent were mixed together to obtain an adhesive coating solution 2.

### <Adhesive coating solution 3>

45 parts by mass of adhesive resin solution 4, and 2 parts by mass of 1,3-bis(N,N'-diglycidylaminomethyl)cyclohexane (manufactured by Mitsubishi Gas Chemical, solid content concentration of 100%, Tetrad-C) as a crosslinking agent were mixed together, and the solid content concentration was adjusted to 30% with ethyl acetate to obtain an adhesive coating solution 3.

### [Example 1]

The adhesive coating solution 1 was coated on a polyethylene terephthalate (PET) film (thickness: 38 µm) as a base material layer, and then dried to form an adhesive resin layer having a thickness of 10 µm to obtain an adhesive film.

The obtained adhesive film was evaluated as follows. The results are summarized in Table 1.

### [Example 2]

An adhesive film was obtained in the same manner as in Example 1 except that the adhesive coating solution 2 was used in place of the adhesive coating solution 1.

The obtained adhesive film was evaluated as follows. The results are summarized in Table 1.

### [Example 3]

An adhesive film was obtained in the same manner as in Example 1 except that the adhesive coating solution 3 was used in place of the adhesive coating solution 1.

The obtained adhesive film was evaluated as follows. The results are summarized in Table 1.

### [Comparative Example 1]

Commercially available adhesive film (trade name: Riva Alpha (registered trademark), manufactured by Nitto Denko Corporation) which is generally used for manufacturing fan-out WLP was evaluated as follows. The results are summarized in Table 1.

### <Evaluations>

### (1) Measurement of surface free energy

Each component (a dispersion component (γa), a polar component (γb), a hydrogen bonding component (γc)) of the surface free energy on a surface of the adhesive resin layer of the respective adhesive films obtained in Examples and Comparative Examples was calculated by an automatic contact angle gauge (CA-V model manufactured by Kyowa Interface Science). In particular, each of distilled water, diiodomethane and 1-bromonaphthalene having a known contact angle was dropped onto the surface of the adhesive resin layer. After 1 second of dropping, the contact angle of each droplet was measured. From the measurement results, each component of the surface free energy on the surface of the adhesive resin layer was calculated. This calculation was performed referring to a method described in "Nara Prefectural Industrial Technology Center, Research Report No.26, 2000)", pages 1 to 2. A sum of the obtained dispersion component (γa), polar component (γb) and hydrogen bonding component (γc) (γa+γb+γc) was calculated as the surface free energy (γ) on the surface of the surface of the adhesive resin layer of the adhesive film.

### (2) Measurement of resin-spreading ratio

First, a hole having a diameter of 2 mm was opened in a polytetrafluoroethylene (PTFE) sheet having a thickness of 130 µm, and the area of the hole was measured in advance with a microscope.

Subsequently, the adhesive films obtained in Examples and Comparative Example were respectively attached to a slide glass with a double-sided adhesive tape with the adhesive resin layer surface facing upward.

Next, the PTFE sheet with a hole was placed on the surface of the adhesive resin layer of the adhesive film, and a liquid epoxy resin based encapsulating material (manufactured by Nagase Chemtex, T693/R4212) was filled in the hole of the PTFE sheet with pouring. The epoxy resin based encapsulating material with a diameter of 2 mm and a thickness of 130 µm was printed on the surface of the adhesive resin layer.

Next, the applied layer was left at 23°C for 1 minute and then heated at 120°C or 150°C for 5 minutes to cure the epoxy resin based encapsulating material. An area of the cured epoxy resin based encapsulating material was measured. The resin-spreading ratio at 120°C or 150°C was calculated as 100 x (X₁-X₀) /X₀ when an area of the epoxy resin based encapsulating material immediately after the epoxy resin based encapsulating material was printed on the adhesive resin layer (that is, an area of the hole in the PTFE sheet) was X₀ and the area of the cured epoxy resin based encapsulating material was X₁.

Evaluation was carried out six times, and an average value thereof was taken as the resin-spreading ratio.

### (3) Evaluation of encapsulating property

A plurality of silicon chips were placed on the adhesive resin layer (300 mm x 300 mm) of each of the adhesive films obtained in Examples and Comparative Example.

Next, the plurality of silicon chips were compression molded and encapsulated on the adhesive resin layer with a liquid epoxy resin based encapsulating material (manufactured by Nagase Chemtex, T693/R4212) using a compression molding machine.

The encapsulating property (encapsulating unevenness) was evaluated according to the following criteria.

O: poor appearance such as flow marks and voids were not observed by visual observation.

X: poor appearance such as flow marks and voids (white turbid part) was observed by visual observation.

### (4) Adhesive residue

The adhesive film was removed from the structure obtained in the evaluation of the encapsulating property. Next, the adhesive residue of the adhesive film was evaluated according to the following criteria.

O: adhesive residue was not observed by visual observation on the silicon chip.

X: adhesive residue was observed by visual observation on the silicon chip.

**[Table 1]**

| | Surface Free Energy [mN/m] | Resin-spreading ratio [%] | | Encapsulating Property [-] | Adhesive Residue [-] |
|---|---|---|---|---|---|
| | | 120°C | 150°C | | |
| Example 1 | 30.6 | 20 | 15 | ∘ | ∘ |
| Example 2 | 34.5 | 10 | 10 | ∘ | ∘ |
| Example 3 | 30.7 | 19 | 16 | ∘ | ∘ |
| Comparative Example 1 | 38.9 | 8 | 7 | × | × |

In Examples 1 to 3, respectively using an adhesive film having a surface free energy on the surface of the adhesive resin layer of equal to or less than 38.0 mN/m, poor appearance such as flow marks and voids was not observed. Furthermore, in Examples 1 to 3, no adhesive residue was observed after peeling off the adhesive film. Therefore, according to the adhesive film 50 of the present embodiment, it is possible to suppress encapsulating unevenness of electronic component when encapsulating the electronic component disposed on the adhesive film with the encapsulating material. Furthermore, it is possible to suppress the adhesive residue on the electronic component when peeling off the adhesive film.

In contrast, in Comparative Example 1 using an adhesive film having a surface free energy on the surface of the adhesive resin layer of greater than 38.0 mN/m, poor appearance such as flow marks and voids was observed. Furthermore, in Comparative Example 1, adhesive residue after peeling of the adhesive film was also observed. Therefore, in the adhesive film of Comparative Example 1, uneven encapsulating of the electronic component occurred when encapsulating the electronic component disposed on the adhesive film with the encapsulating material, and adhesive residue was left on the electronic component when peeling off the adhesive film.

## Claims

1. An adhesive film for temporarily fixing an electronic component when encapsulating the electronic component with an epoxy resin based encapsulating material by compression molding in a manufacturing process of a semiconductor device, the film comprising:
a base material layer; and
an adhesive resin layer (A) provided on a first surface side of the base material layer for temporarily fixing the electronic component,
**characterized in that** the surface free energy of a surface of the adhesive resin layer (A) is equal to or more than 20.0 mN/m and equal to or less than 38.0 mN/m.

2. The adhesive film according to claim 1, further comprising: an adhesive resin layer (B) provided on a second surface side opposite to the first surface side of the base material layer, wherein the adhesive force of the adhesive resin layer (B) is configured to be lowered by external stimulation.

3. The adhesive film according to claim 2, wherein the adhesive force of the adhesive resin layer (B) is configured to be lowered by heating.

4. The adhesive film according to any one of claims 1 to 3, wherein the adhesive resin layer (A) contains a (meth)acrylic adhesive.

5. A method for manufacturing a semiconductor device at least comprising:
(A) a step of preparing a structure including an adhesive film and an electronic component temporarily fixed to the adhesive film;
(B) a step of encapsulating the electronic component with an epoxy resin based encapsulating material by compression molding; and
(C) a step of removing the adhesive film from the electronic component,
wherein the adhesive film is the adhesive film according to any one of claims 1 to 4.

6. The method for manufacturing a semiconductor device according to claim 5,
wherein a resin-spreading ratio at 150°C is equal to or more than 8%, which is measured by applying the epoxy resin based encapsulating material with a diameter of 2 mm and a thickness of 130 µm to a surface of the adhesive resin layer (A) ; leaving the applied layer at 23°C for 1 minute and then heating at 150°C for 5 minutes to cure the epoxy resin based encapsulating material; measuring an area of the cured epoxy resin based encapsulating material; and calculating the resin-spreading ratio at 150°C as 100 x (X₁-X₀) /X₀ when an area of the epoxy resin based encapsulating material immediately after applied on the adhesive resin layer (A) is X₀ and the area of the cured epoxy resin based encapsulating material is X₁.

## Patentansprüche

1. Haftfolie zur vorübergehenden Fixierung eines elektronischen Bauteils beim Verkapseln des elektronischen Bauteils mit einem epoxidharzbasierten Verkapselungsmaterial durch Formpressen in einem Herstellungsverfahren einer Halbleitervorrichtung, wobei die Folie umfasst:
eine Basismaterialschicht; und
eine Klebharzschicht (A), angeordnet auf einer ersten Oberflächenseite der Basismaterialschicht, zur vorübergehenden Fixierung des elektronischen Bauteils,
**dadurch gekennzeichnet, dass**
die freie Oberflächenenergie einer Oberfläche der Klebharzschicht (A) gleich oder mehr als 20,0 mN/m und gleich oder weniger als 38,0 mN/m ist.

2. Haftfolie gemäß Anspruch 1, ferner umfassend:
eine Klebharzschicht (B), angeordnet auf einer zweiten Oberflächenseite der Basismaterialschicht, die der ersten Oberflächenseite gegenüber liegt, wobei die Klebkraft der Klebharzschicht (B) konfiguriert ist, durch äußere Stimulation verringert zu werden.

3. Haftfolie gemäß Anspruch 2,
wobei die Klebkraft der Klebharzschicht (B) konfiguriert ist, durch Erwärmen verringert zu werden.

4. Haftfolie gemäß einem der Ansprüche 1 bis 3,
wobei die Klebharzschicht (A) einen (Meth)acrylatklebstoff enthält.

5. Verfahren zur Herstellung einer Halbleitervorrichtung, mindestens umfassend:
(A) einen Schritt des Herstellens einer Struktur, enthaltend eine Haftfolie und ein elektronisches Bauteil, das vorübergehend an der Haftfolie fixiert ist;
(B) einen Schritt des Verkapselns des elektronischen Bauteils mit einem epoxidharzbasierten Verkapselungsmaterial durch Formpressen; und
(C) einen Schritt des Entfernens der Haftfolie von dem elektronischen Bauteil,
wobei die Haftfolie die Haftfolie gemäß einem der Ansprüche 1 bis 4 ist.

6. Verfahren zur Herstellung einer Halbleitervorrichtung gemäß Anspruch 5,
wobei ein Harzausbreitungsverhältnis bei 150°C gleich oder größer als 8% ist, was gemessen wird, indem das epoxidharzbasierte Verkapselungsmaterial mit einem Durchmesser von 2 mm und einer Dicke von 130 µm auf eine Oberfläche der Klebharzschicht (A) aufgebracht wird; die aufgebrachte Schicht bei 23°C für 1 Minute belassen und anschließend auf 150°C für 5 Minuten erhitzt wird, um das epoxidharzbasierte Verkapselungsmaterial zu härten; eine Fläche des gehärteten epoxidharzbasierten Verkapselungsmaterials gemessen wird; und das Harzverteilungsverhältnis bei 150°C als 100 x (X₁-X₀) /X₀ berechnet wird, wenn eine Fläche des epoxidharzbasierten Verkapselungsmaterials unmittelbar nach dem Aufbringen auf die Klebharzschicht (A) X₀ ist und die Fläche des gehärteten epoxidharzbasierten Verkapselungsmaterials X₁ ist.

## Revendications

1. Film adhésif pour fixer temporairement un composant électronique lors de l'encapsulation du composant électronique avec un matériau d'encapsulation à base de résine époxy par moulage par compression dans un processus de fabrication d'un dispositif à semi-conducteur, le film comprenant :
une couche de matériau de base ; et
une couche de résine adhésive (A) disposée sur un premier côté de surface de la couche de matériau de base pour fixer temporairement le composant électronique,
**caractérisé en ce que** l'énergie libre de surface d'une surface de la couche de résine adhésive (A) est égale ou supérieure à 20,0 mN/m et égale ou inférieure à 38,0 mN/m.

2. Film adhésif selon la revendication 1, comprenant en outre :
une couche de résine adhésive (B) disposée sur un second côté de surface opposé au premier côté de surface de la couche de matériau de base, dans lequel la force adhésive de la couche de résine adhésive (B) est configurée pour être abaissée par une stimulation externe.

3. Film adhésif selon la revendication 2,
dans lequel la force adhésive de la couche de résine adhésive (B) est configurée pour être abaissée par chauffage.

4. Film adhésif selon l'une quelconque des revendications 1 à 3, dans lequel la couche de résine adhésive (A) contient un adhésif (méth)acrylique.

5. Procédé pour fabriquer un dispositif à semi-conducteur comprenant au moins :
(A) une étape consistant à préparer une structure incluant un film adhésif et un composant électronique fixé temporairement au film adhésif ;
(B) une étape consistant à encapsuler le composant électronique avec un matériau d'encapsulation à base de résine époxy par moulage par compression ; et
(C) une étape consistant à retirer le film adhésif du composant électronique,
dans lequel le film adhésif est le film adhésif selon l'une quelconque des revendications 1 à 4.

6. Procédé pour fabriquer un dispositif à semi-conducteur selon la revendication 5,
dans lequel un rapport de propagation de la résine à 150 °C est égal ou supérieur à 8 %, lequel est mesuré en appliquant le matériau d'encapsulation à base de résine époxy avec un diamètre de 2 mm et une épaisseur de 130 µm sur une surface de la couche de résine adhésive (A) ; en laissant la couche appliquée à 23 °C pendant 1 minute et en chauffant ensuite à 150 °C pendant 5 minutes pour durcir le matériau d'encapsulation à base de résine époxy ; en mesurant une aire du matériau d'encapsulation à base de résine époxy durci ; et en calculant le rapport de propagation de la résine à 150 °C comme étant 100 x (X₁-X₀) /X₀ lorsqu'une aire du matériau d'encapsulation à base de résine époxy immédiatement après une application sur la couche de résine adhésive (A) est Xo et l'aire du matériau d'encapsulation à base de résine époxy durci est X₁.
